# EUROPÄISCHE PATENTANMELDUNG

(11) **EP 2 410 571 A1**
(43) Veröffentlichungstag der Anmeldung: **25.01.2012**
(21) Anmeldenummer: 10170208.2
(22) Anmeldetag: 20.07.2010
(51) Int. Cl.: H01L 31/04, H01L 31/075, H01L 31/0392, H01L 31/18

(54) **Photovoltaisches Beschichtungsystem**

(71) Anmelder: Lenz, Christian, 68259 Mannheim (DE)
(72) Erfinder: Lenz, Christian, 68259 Mannheim (DE)
(74) Vertreter: Sartorius, Peter

(57) **Zusammenfassung**

Die Erfindung bezieht sich auf ein Beschichtungssystem (1) für Oberflächen insbesondere für Wande und/oder Dachoberflächen (2), das als Fotovoltaikmodul oder Solargenerator, eingesetzt und zur Erzeugung von Energie dem Licht ausgesetzt wird, bestehend aus auf der Wand oder Dachoberfläche (2) aufgebrachtem Material, bestehend aus zumindest einer p-dotierten leitenden Halbleiterschicht (9) mit einer Grenzschicht (11), einer auf dieser aufgebrachten n-dotierten Halbleiterschicht (8), in der Leitelemente (5) eingebracht sind, und einer auf die n-dotierte Halbleiterschicht (8) aufgebrachten Isolierschicht, wobei zumindest eine Halbleiterschicht (9) mittel-oder unmittelbar auf die Wand oder Dachoberfläche (2) aufgebracht und mit dieser verbunden ist, und beide Halbleiterschichten (8, 9) aus einem Material gebadet sind, in das Halbleiterelemente eingebracht sind.

## Beschreibung

Die Erfindung betrifft ein Beschichtungssystem für Oberflächen, insbesondere für Wände und/oder Dachoberflächen, das als Fotovoltaikmodul oder Solargenerator, eingesetzt und zur Erzeugung von Energie dem Licht ausgesetzt wird, bestehend aus auf der Wand oder Dachoberfläche aufgebrachtem Material, aus zumindest einer p-dotierten leitenden Halbleiterschicht mit einer Grenzschicht, einer auf dieser aufgebrachten n-dotierten Halbleiterschicht, in der Leitelemente eingebracht sind und einer auf die n-dotierte Halbleiterschicht aufgebrachten Isolierschicht.

Es sind bereits Solarmodule, Photovoltaikmodule oder Solargeneratoren allgemein bekannt, die das Licht der Sonne direkt in elektrische Energie umwandeln. Als wichtigste Bestandteile enthalten die Module mehrere Solarzellen.

Solarmodule werden einzeln oder in Gruppen verschaltet in Fotovoltaikanlagen, kleinen Stromnetz unabhängigen Verbrauchern oder zur Stromversorgung von Raumfahrzeugen verwendet.

Ein Solarmodul wird durch seine elektrischen Anschlusswerte (z. B. Leerlaufspannung und Kurzschlussstrom) charakterisiert. Diese hängen von den Eigenschaften der einzelnen Solarzellen und der Verschaltung der Solarzellen innerhalb des Moduls ab.

Um den Anforderungen einer Anlage für solar erzeugten Strom gerecht zu werden, fasst man Solarzellen mittels mehrerer verschiedener Materialien zu einem Solarmodul zusammen. Dieser Verbund erfüllt folgende Zwecke: transparente, strahlungs- und witterungsbeständige Abdeckung, robuste elektrische Anschlüsse, Schutz der spröden Solarzelle vor mechanischen Einflüssen, Schutz der Solarzellen und elektrischen Verbindungen vor Feuchtigkeit, ausreichende Kühlung der Solarzellen, Berührungsschutz der elektrisch leitenden Bauteile sowie einfache Handhabungs- und Befestigungsmöglichkeit.

Es gibt verschiedene Bauformen von Solarmodulen mit verschiedenen Arten von Solarzellen. Im Folgenden wird anhand des weltweit am häufigsten eingesetzten Modultyps der Aufbau erwähnt.

Die Solarzelle oder fotovoltaische Zelle ist ein elektrisches Bauelement, das kurzwellige Strahlungsenergie, in der Regel Sonnenlicht, direkt in elektrische Energie wandelt. Die physikalische Grundlage der Umwandlung ist der fotovoltaische Effekt, der ein Sonderfall des inneren fotoelektrischen Effekts ist.

Solarzellen unterscheiden sich dadurch grundsätzlich von anderen Arten der regenerativen Elektrizitätserzeugung, bei denen lediglich die Antriebsenergie für den Generator nicht konventionell erzeugt wird.

Unter dem Begriff fotoelektrischer Effekt, auch lichtelektrischer Effekt oder kurz Fotoeffekt werden vier nahe verwandte, aber unterschiedliche Phänomene in der Physik zusammengefasst. In allen vier Fällen wird ein Foton von einem Elektron, das z. B. in einem Atom oder im Leitungsband eines metallischen Körpers gebunden ist, absorbiert und das Elektron dadurch aus der Bindung gelöst. Die Energie des Fotons muss dazu mindestens so groß sein, wie die Bindungsenergie des Elektrons.

Je nach dem Zustand des Elektrons vor der Energieübertragung unterscheidet man vier Arten des fotoelektrischen Effekts:
Als äußeren fotoelektrischen Effekt auch Fotoemission oder Hallwachs-Effekt) bezeichnet man das Herauslösen von Elektronen aus Metalloberflächen durch Bestrahlung mit Licht bestimmter Frequenzen.

Der innere fotoelektrische Effekt tritt in Halbleitern auf. Darauf aufbauend ermöglicht der fotovoltaische Effekt die Umwandlung von Lichtenergie in elektrische Energie.

Unter Foto-Ionisation auch atomarer oder molekularer Fotoeffekt) versteht man die Ionisierung von Atomen durch Bestrahlung mit Licht genügend hoher Frequenzen. Eine derartige Vorrichtung und Anordnung bzw. der Aufbau derartiger Module ist in der Herstellung aufwändig und teuer. Hier will die Erfindung Abhilfe schaffen.

Es ist ein Beschichtungssystem für Oberflächen, insbesondere für Wände und/oder Dachoberflächen, das als Fotovoltaikmodul oder Solargenerator, eingesetzt und zur Erzeugung von Energie dem Licht ausgesetzt wird aus der US 2009 / 0133340 A1 bekannt, bestehend aus auf der Wand oder Dachoberfläche aufgebrachtem Material, bestehend aus zumindest einer p-dotierten leitenden Halbleiterschicht mit einer Grenzschicht, einer auf dieser aufgebrachten n-dotierten Halbleiterschicht, in der Leitelemente eingebracht sind, und einer auf die n-dotierte Halbleiterschicht aufgebrachten Isolierschicht. Bei dieser Anordnung ist es nachteilig, dass die eine Halbleiterschicht mit Hilfe eines Haftvermittlersystems unmittelbar auf die Wand oder Dachoberfläche aufgebracht ist. Hierdurch wird die Montage von Halbleitersystemen bzw. Schichten aufwändig und teuer.

Ferner ist es aus der US 2009 / 0133340 A1 bekannt, dass die Leitelemente in die Oberfläche der Lichtenergie ausgesetzten, lichtdurchlässigen Schicht eingebracht sind und die der Lichtenergie ausgesetzte Schicht eine n-dotierte Schicht aus Silizium oder Galliumarsenid oder Kupfer-Indium-Diselenid ist, wobei die der Lichtenergie ausgesetzte, negativ geladene Schicht auf der p-dotierten Schicht aufgebracht ist, die mittel- oder unmittelbar auf einer Wand oder Dachoberfläche aufgebracht ist. Aus diesem Dokument ist es ferner bekannt, dass die positiv-dotierte Schicht und die Wand oder die Dachoberfläche mit Hilfe eines Klebeprozesses zusammengebracht werden können.

Ferner ist aus der DE 44 35 376 A1 bekannt, die Dispergierbarkeit des ITO-Pulvers, bevor es in einer Bindemittellösung dispergiert wird, mit einem Dispergiermittel oder durch Zugabe eines Dispergiermittels zu der Bindemittellösung zu verbessern. Die Verwendung eines Dispergiermittels macht es jedoch schwierig, den Widerstand des resultierenden Films auf einen erwünschten Wert zu verringern. Es wird angenommen, dass die Dispersion der ITO-Teilchen unter Zuhilfenahme eines Dispergiermittels bewirkt, dass das Bindemittel und das Dispergiermittel durch die Teilchen innig adsorbiert werden unter Ausbildung einer Isolationsschicht auf der Oberfläche jedes Teilchens, wodurch es schwierig wird, den Widerstand eines ITO-Pulver enthaltenden, leitfähigen Films zu verringern.

Der Erfindung liegt die Aufgabe zugrunde; die Photovoltaikmodule oder Solargeneratoren und das Beschichtungssystem auf einfache und kostengünstige Weise herzustellen.

Die Aufgabe wird erfindungsgemäß dadurch gelöst, dass zumindest eine Halbleiterschicht bzw. Halbleiterelemente mittelbar auf die Wand oder Dachoberfläche aufgebracht und mit dieser verbunden ist. Beide Halbleiterschichten sind aus einem Material gebildet, in das Halbleiterelemente eingebracht sind. Hierdurch wird die Herstellung wesentlich vereinfacht und somit auch verbilligt, da das Photovoltaikmodul oder der Solargenerator bzw. das Beschichtungssystem auf einfache Weise auf Wände oder Dächer aufgebracht werden kann, ohne die Oberflächenstruktur bzw. das Aussehen der Oberfläche wesentlich zu verändern. Da das Material des Beschichtungssystems aus einem fließfähigen, schüttfähigen, streichfähigen oder flockigen Material besteht, kann es problemlos auf die Oberfläche eines Untergrunds z. B. eines Dachs oder einer Wand bzw. auf einem Boden dauerfest aufgetragen und fixiert werden. In dem Gemisch kann auch eine klebfähige Substanz eingebracht sein, um die Haftfähigkeit auf dem Untergrund zu verbessern.

Hierzu ist es vorteilhaft, dass das Material als streich-, schütt-, fließfähiges Material ausgebildet ist, in das die als Chips ausgebildeten Halbleiterelemente derart zahlreich eingebracht sind, dass sie untereinander in Kontakt stehen und die Halbleiterschicht bilden.

Auch ist es von Vorteil, dass auf oder in die n-dotierte Halbleiterschicht Leitelemente eingebracht sind, die aus zahlreichen, untereinander in Verbindung stehenden Leiterbahnen, Leiterelemente bzw. Leitflächenteilen oder einem Leitgitter gebildet sind.

Ferner ist es vorteilhaft, dass die Leitelemente in die Oberfläche der Lichtenergie ausgesetzten, lichtdurchlässigen Schicht eingebracht sind und dass diese Schicht eine n-dotierte Schicht aus Silizium oder Galliumarsenid oder Kupfer-Indium-Diselenid ist.

Vorteilhaft ist es auch, dass die der Lichtenergie ausgesetzte, negativ geladene Schicht auf der p-dotierten Schicht aufgebracht ist, die mittel- oder unmittelbar auf einer Wand oder Dachoberfläche aufgebracht ist.

Von Vorteil ist es auch, dass zwischen der positiv-dotierten Schicht und der Wand oder der Dachoberfläche eine Klebeverbindung vorgesehen ist.

Von besonderer Bedeutung ist für die vorliegende Erfindung, dass die Halbleiterschichten eine streichbare Farbemasse sind, in der Halbleiterelemente eingebracht sind und die schichtweise auf der Wand oder Dachoberfläche aufgebracht werden. Durch das schichtweise Aufbringen wird der Fertigungsprozess wesentlich schneller durchgeführt. Außerdem ist es vorteilhaft, dass als Trägerschicht ein Spinnvlies oder ein Bändchengewebe verwendet wird.

Auch ist es vorteilhaft, dass die Halbleiterschicht eine elektrisch leitende Farbe ist, die insbesondere auf der Basis einer Kunststoffdispersionsfarbe mit Bindemittel aufgebaut ist. Mit Hilfe der Kunststoffdispersionsfarbe kann die Oberfläche beliebig gestaltet werden und gleichzeitig auch zur Stromgewinnung eingesetzt werden.

Ferner ist es vorteilhaft, dass die Halbleiterschichten aus einem fließfähigen, schüttfähigen oder flockigen Material bestehen, in das Halbleiterelemente wie Silizium, Galliumarsenid oder Kupfer-Indium-Diselenid als kleine Teilchen eingebracht, insbesondere mittels eines Werkzeugs eingeschossen werden und eine leitfähige Masse bilden, die als p-dotierte und dann als n-dotierte Schicht auf die Wand oder Dachoberfläche, insbesondere nacheinander, aufgebracht werden, wobei die obere Halbleiterschicht eine lichtdurchlässige Schutzschicht aufweist und die die Halbleiterelemente aufweisende Schicht in ein Klebebett eingebracht wird.

Vorteilhaft ist es auch, dass zumindest die p-Schicht als elektrisch leitende Kunststofffarbe ausgebildet ist, in der die Halbleiterelemente wie Silizium, oder Kupfer-Indium-Diselenid oder Galliumarsenid eingebracht sind.

Ferner ist es vorteilhaft, dass zwischen den beiden Halbleiterschichten die nichtleitende Grenzschicht vorgesehen ist, die ebenfalls als streichbare Masse ausgebildet ist.

Eine zusätzliche Möglichkeit ist gemäß einer Weiterbildung der Erfindung, dass auf der oberen n-dotierten Halbleiterschicht aufgebrachte Leiterbahnen, Leitflächenteile oder ein Leitgitter mit Hilfe eines Haftverbinders fixiert sind.

Von Vorteil ist es auch, dass die einzelnen Schichten aus einem fließ- oder schüttfähigen Material bestehen und nacheinander auf eine Oberfläche aufgetragen werden.

Weitere Vorteile und Einzelheiten der Erfindung sind in den Patentansprüchen und in der Beschreibung erläutert und in den Figuren dargestellt.

Dabei zeigen:
- Fig. 1: einen Aufbau einer Solarzelle,
- Fig. 2: ein Klebebett der Solarzelle, das auf der Oberfläche eines Dachs aufgebracht ist.

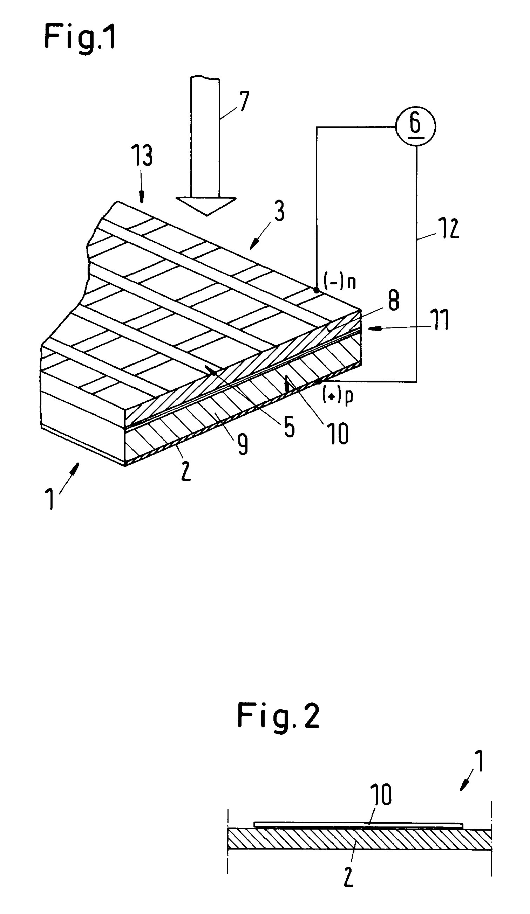

In Fig.1 ist ein Beschichtungssystem 1 für Oberflächen insbesondere für Wände und/oder Dachoberflächen 2 bezeichnet, das als Fotovoltaikmodul oder Solargeneratoren 3, ausgebildet ist, die zur Erzeugung von Energie dem Licht ausgesetzt werden.

Die Energieerzeugung mit Solarzellen sowie deren Entwicklung, Fertigung und Einsatz werden hier Fotovoltaik genannt. Die Umwandlung der Strahlungs- in elektrische Energie in den Solarzellen beruht auf dem inneren Fotoeffekt im Halbleitermaterial. Die Solarzellen sind nachstehend näher erläutert. Elektrische Kontakte werden nachträglich aufgeklebt, aufgedruckt oder aufgedampft.

Die Solarzellen bestehen aus Halbleitermaterialien z. B. Silizium, Germanium, Galliumarsenid oder einem ähnlich einsatzfähigen Stoff, der das Sonnenlicht absorbiert und in Gleichstrom umwandelt. Diese direkte Umwandlung von Licht in elektrische Energie in einem Festkörper wird als fotovoltaischer Effekt bezeichnet. Die Lichteinstrahlung setzt im Halbleiter negative und positive Ladungsträger frei. Ein internes elektrisches Feld trennt diese Ladungsträger. Auf diese Weise entsteht eine elektrische Spannung zwischen den Metallkontakten, die an der Oberfläche der Solarzellen angebracht sind. Wird der äußere Kreis über eine Leitung 12 geschlossen, so fließt ein elektrischer Gleichstrom, der einem Verbraucher 6 zugeführt werden kann. Die weitaus meisten heute hergestellten Solarzellen bestehen aus Silizium.

Das in Fig. 1 teilweise dargestellte Modul bildet die Grundeinheit der hier nur zum Teil dargestellten Fotovoltaikanlage. Werden die Solarzellen in Reihe geschaltet, entsteht ein String. Mehrere Module in Reihe geschaltet bilden einen Strang.

Die in Fig. 1 dargestellten Solarzellen bestehen aus hoch reinem Silizium. Sie setzen sich aus einer n-leitenden Schicht 8 und einer p-leitenden Schicht 9 zusammen. An einer Grenzschicht 11 beider Schichten 8, 9 baut sich ein elektrisches Feld auf. Fällt Licht auf die Zelle, so werden unterschiedliche Ladungsträger frei gesetzt. Das elektrische Feld trennt die Ladungsträger, wodurch Spannung über die Anschlusskontakte der Zelle erzeugt wird. Schaltet man ein Gerät, hier den Verbraucher 6, über die Leitung 12 zwischen diese Kontakte, so kann Strom fließen. Die Anschlusskontakte bestehen aus einer ganzflächigen Metallschicht auf der Unterseite und fingerartig gestalteten Metallkontakten auf der Oberseite, damit Sonnenlicht auf die Halbleiterschicht einfallen kann. Um Verluste durch Reflexion zu verringern, wird auf der Oberseite eine bläuliche Antireflexschicht aufgetragen. Den besten Wirkungsgrad erreichen monokristalline Zellen. Allerdings ist die Herstellung von Silizium-Einkristallen aufwendig und teuer. Etwas preiswerter lassen sich polykristalline Zellen (aus vielen Kristallen) fertigen, die aber weniger effizient sind. Es ist mit dieser Anlage möglich, 30 % der einfallenden Sonnenenergie in Strom umzuwandeln.

Beispielsweise kann amorphes Silizium (die Moleküle sind nicht als Kristallgitter regelmäßig angeordnet) in Form von kleinen Plättchen bzw. Flitter in ein Trägermaterial, insbesondere auf ein streichfähiges, schüttfähiges, fließfähiges Material, wenige mm dick eingebracht werden, z. B. Material aus Gallium-Arsenid (GaAs) oder Kupfer-Indium-Diselenid (CIS).

Für technische Anwendungen schaltet man mehrere Zellen in Reihe, wobei sich die Spannungen summieren. Nach diesem Ausführungsbeispiel ist es möglich, eine sehr große zusammenhängende Grundfläche zu schaffen und damit hohe Wattzahlen zu erzielen.

Das hier eingesetzte Material ist, wie bereits erwähnt, als streichfähiges, schüttfähiges, fließfähiges Material gebildet. Es kann beispielsweise Kunststoffdispersionsfarbe auf der Basis eines geeigneten Bindemittels sein. Die als Chips ausgebildeten Halbleiterelemente wie Silizium (SI), Gallium-Arsenid (GaAs) oder Kupfer-Indium-Diselenid (CIS) sind derart zahlreich in die Halbleiterschichten 8, 9 eingebracht, dass sie untereinander in Kontakt stehen. Das Beschichtungssystem 1 ist für Oberflächen, insbesondere als Halbleiterschichten 8 und 9 geeignet, lässt sich einfach auf die Oberfläche aufbringen, streichen, gießen oder schütten und ist zur Erzeugung von Energie aus Licht einzusetzen.

Das Beschichtungssystem 1 besteht aus zwei Halbleiterelemente aufweisenden Schichten, nachstehend als Halbleiterschicht 8 und 9 bezeichnet, die wie bereits erwähnt durch eine Grenzschicht 11 getrennt sind. Die Halbleiterelemente bzw. der Flitter können mit Hilfe einer Sprühpistole in die Masse eingebracht werden. Die einzelnen Schichten z. B. eine Klebeschicht 10, die Halbleiterschichten 8 und 9 sowie eine Grenzschicht 11 können nacheinander auf die Wand oder Dachoberfläche 2 aufgebracht werden, die sich aufgrund der Materialeigenschaften miteinander verbinden. Zum Abschluss werden Leiterbahnen, Leitflächenteile oder Leitgitter 5 aufgebracht, z. B. verklebt, die dann mit einer lichtdurchlässigen Schutzschicht 13 überzogen werden. Die obere n-dotierte Schicht 8 und die unter p-dotierte Schicht 9 werden an den Verbraucher 6 angeschlossen.

## Patentansprüche

1. Beschichtungssystem (1) für Oberflächen, insbesondere für Wände und/oder Dachoberflächen (2), das als Fotovoltaikmodul oder Solargenerator, eingesetzt und zur Erzeugung von Energie dem Licht ausgesetzt wird, bestehend aus auf der Wand oder Dachoberfläche (2) aufgebrachtem Material, bestehend aus zumindest einer p-dotierten leitenden Halbleiterschicht (9) mit einer Grenzschicht (11), einer auf dieser aufgebrachten n-dotierten Halbleiterschicht (8), in der Leitelemente (5) eingebracht sind, und einer auf die n-dotierte Halbleiterschicht (8) aufgebrachten Isolierschicht,
**dadurch gekennzeichnet,**
**dass** zumindest eine Halbleiterschicht (9) mittelbar auf die Wand oder Dachoberfläche (2) aufgebracht und mit dieser verbunden ist, wobei beide Halbleiterschichten (8, 9) aus einem Material gebildet sind, in das Halbleiterelemente eingebracht sind.

2. Beschichtungssystem nach Anspruch 1,
**dadurch gekennzeichnet,**
**dass** das Material als streich-, schütt-, fließfähiges Material ausgebildet ist, in das die als Chips ausgebildeten Halbleiterelemente derart zahlreich eingebracht sind, dass sie untereinander in Kontakt stehen und die Halbleiterschicht (8, 9) bilden.

3. Beschichtungssystem nach Anspruch 1 oder 2,
**dadurch gekennzeichnet,**
**dass** auf oder in die n-dotierte Halbleiterschicht (8) Leitelemente (5) eingebracht sind, die aus zahlreichen, untereinander in Verbindung stehenden Leiterbahnen, Leiterelemente bzw. Leitflächenteilen oder einem Leitgitter gebildet sind.

4. Beschichtungssystem nach **Anspruch 1**,
**dadurch gekennzeichnet,**
**dass** die Leitelemente (5) in die Oberfläche der Lichtenergie (7) ausgesetzten, lichtdurchlässigen Schicht (8) eingebracht sind.

5. Beschichtungssystem nach **Anspruch 1**,
**dadurch gekennzeichnet,**
**dass** die der Lichtenergie (7) ausgesetzte Schicht (8) eine n-dotierte Schicht aus Silizium oder Galliumarsenid oder Kupfer-Indium-Diselenid ist.

6. Beschichtungssystem nach **Anspruch 1**,
**dadurch gekennzeichnet,**
**dass** die der Lichtenergie (7) ausgesetzte, negativ geladene Schicht (8) auf der p-dotierten Schicht (9) aufgebracht ist, die mittel- oder unmittelbar auf einer Wand oder Dachoberfläche (2) aufgebracht ist.

7. Beschichtungssystem nach **Anspruch 1**,
**dadurch gekennzeichnet,**
**dass** zwischen der positiv-dotierten Schicht (9) und der Wand oder der Dachoberfläche (2) eine Klebeverbindung (10) vorgesehen ist.

8. Beschichtungssystem nach einem der vorhergehenden Ansprüche,
**dadurch gekennzeichnet,**
**dass** die Halbleiterschichten (8, 9) eine streichbare Farbemasse sind, in der Halbleiterelemente eingebracht sind und die schichtweise auf der Wand oder Dachoberfläche (2) aufgebracht werden.

9. Beschichtungssystem nach **Anspruch 1**,
**dadurch gekennzeichnet,**
**dass** die Halbleiterschicht (8, 9) eine elektrisch leitende Farbe ist, die insbesondere auf der Basis einer Kunststoffdispersionsfarbe mit Bindemittel aufgebaut ist.

10. Beschichtungssystem nach einem der vorhergehenden Ansprüche,
**dadurch gekennzeichnet,**
**dass** die Halbleiterschichten (8, 9) aus einem fließfähigen, schüttfähigen oder flockigen Material bestehen, in das Halbleiterelemente wie Silizium, Galliumarsenid oder Kupfer-Indium-Diselenid als kleine Teilchen eingebracht, insbesondere mittels eines Werkzeugs eingeschossen werden und eine leitfähige Masse bilden, die als p-dotierte und dann als n-dotierte Schicht auf die Wand oder Dachoberfläche (2) insbesondere nacheinander aufgebracht werden, wobei die obere Halbleiterschicht (8) eine lichtdurchlässige Schutzschicht (13) aufweist.

11. Beschichtungssystem nach einem der vorhergehenden Ansprüche,
**dadurch gekennzeichnet,**
**dass** die die Halbleiterelemente aufweisenden Schichten (8, 9) aus einem fließfähigen, schüttfähigen oder flockigen Material bestehen, das in ein Klebebett eingebracht wird.

12. Beschichtungssystem nach einem der vorhergehenden Ansprüche,
**dadurch gekennzeichnet,**
**dass** zumindest die p-Schicht als elektrisch leitende Kunststofffarbe ausgebildet ist, in der die Halbleiterelemente wie Silizium, oder Kupfer-Indium-Diselenid oder Galliumarsenid eingebracht sind.

13. Beschichtungssystem nach einem der vorhergehenden Ansprüche,
**dadurch gekennzeichnet,**
**dass** zwischen den beiden Halbleiterschichten (8, 9) die nichtleitende Grenzschicht (11) vorgesehen ist, die ebenfalls als streichbare Masse ausgebildet ist.

14. Beschichtungssystem nach einem der vorhergehenden Ansprüche,
**dadurch gekennzeichnet,**
**dass** auf der oberen n-dotierten Halbleiterschicht (8) aufgebrachte Leiterbahnen, Leitflächenteile oder ein Leitgitter (5) mit Hilfe eines Haftverbinders fixiert sind.

15. Beschichtungssystem nach einem der vorhergehenden Ansprüche,
**dadurch gekennzeichnet,**
**dass** die einzelnen Schichten (8, 9, 11, 14) aus einem fließ- oder schüttfähigen Material bestehen und nacheinander auf eine Oberfläche aufgetragen werden.

## Geänderte Patentansprüche

### Geänderte Patentansprüche gemäss Regel 137(2) EPÜ.

**1.** Beschichtungssystem (1) für Oberflächen, insbesondere für Wände und/oder Dachoberflächen (2), das als Fotovoltaikmodul oder Solargenerator, eingesetzt und zur Erzeugung von Energie dem Licht ausgesetzt wird, bestehend aus auf der Wand oder Dachoberfläche (2) aufgebrachtem Material, bestehend aus zumindest einer p-dotierten leitenden Halbleiterschicht (9) mit einer Grenzschicht (11), einer auf dieser aufgebrachten n-dotierten Halbleiterschicht (8), in der Leitelemente (5) eingebracht sind, und einer auf die n-dotierte Halbleiterschicht (8) aufgebrachten Isolierschicht,
**dadurch gekennzeichnet,**
**dass** zumindest eine Halbleiterschicht (9) unmittelbar auf die Wand oder Dachoberfläche (2) aufgebracht und mit dieser verbunden ist, wobei beide Halbleiterschichten (8, 9) aus einem Material gebildet sind, in das Halbleiterelemente eingebracht sind.

**2.** Beschichtungssystem nach Anspruch 1,
**dadurch gekennzeichnet,**
**dass** das Material als streich-, schütt-, fließfähiges Material ausgebildet ist, in das die als Chips ausgebildeten Halbleiterelemente derart zahlreich eingebracht sind, dass sie untereinander in Kontakt stehen und die Halbleiterschicht (8, 9) bilden.

**3.** Beschichtungssystem nach Anspruch 1 oder 2,
**dadurch gekennzeichnet,**
**dass** auf oder in die n-dotierte Halbleiterschicht (8) Leitelemente (5) eingebracht sind, die aus zahlreichen, untereinander in Verbindung stehenden Leiterbahnen, Leiterelemente bzw. Leitflächenteilen oder einem Leitgitter gebildet sind.

**4.** Beschichtungssystem nach Anspruch 1,
**dadurch gekennzeichnet,**
**dass** die Leitelemente (5) in die Oberfläche der Lichtenergie (7) ausgesetzten, lichtdurchlässigen Schicht (8) eingebracht sind.

**5.** Beschichtungssystem nach Anspruch 1,
**dadurch gekennzeichnet,**
**dass** die der Lichtenergie (7) ausgesetzte Schicht (8) eine n-dotierte Schicht aus Silizium oder Galliumarsenid oder Kupfer-Indium-Diselenid ist.

**6.** Beschichtungssystem nach Anspruch 1,
**dadurch gekennzeichnet,**
**dass** die der Lichtenergie (7) ausgesetzte, negativ geladene Schicht (8) auf der p-dotierten Schicht (9) aufgebracht ist, die unmittelbar auf einer Wand oder Dachoberfläche (2) aufgebracht ist.

**7.** Beschichtungssystem nach Anspruch 1,
**dadurch gekennzeichnet,**
**dass** zwischen der positiv-dotierten Schicht (9) und der Wand oder der Dachoberfläche (2) eine Klebeverbindung (10) vorgesehen ist.

**8.** Beschichtungssystem nach einem der vorhergehenden Ansprüche,
**dadurch gekennzeichnet,**
**dass** die Halbleiterschichten (8, 9) eine streichbare Farbemasse sind, in der Halbleiterelemente eingebracht sind und die schichtweise auf der Wand oder Dachoberfläche (2) aufgebracht werden.

**9.** Beschichtungssystem nach Anspruch 1,
**dadurch gekennzeichnet,**
**dass** die Halbleiterschicht (8, 9) eine elektrisch leitende Farbe ist, die insbesondere auf der Basis einer Kunststoffdispersionsfarbe mit Bindemittel aufgebaut ist.

**10.** Beschichtungssystem nach einem der vorhergehenden Ansprüche,
**dadurch gekennzeichnet,**
**dass** die Halbleiterschichten (8, 9) aus einem fließfähigen, schüttfähigen oder flockigen Material bestehen, in das Halbleiterelemente wie Silizium, Galliumarsenid oder Kupfer-Indium-Diselenid als kleine Teilchen eingebracht, insbesondere mittels eines Werkzeugs eingeschossen werden und eine leitfähige Masse bilden, die als p-dotierte und dann als n-dotierte Schicht auf die Wand oder Dachoberfläche (2) insbesondere nacheinander aufgebracht werden, wobei die obere Halbleiterschicht (8) eine lichtdurchlässige Schutzschicht (13) aufweist.

**11.** Beschichtungssystem nach einem der vorhergehenden Ansprüche,
**dadurch gekennzeichnet,**
**dass** die die Halbleiterelemente aufweisenden Schichten (8, 9) aus einem fließfähigen, schüttfähigen oder flockigen Material bestehen, das in ein Klebebett eingebracht wird.

**12.** Beschichtungssystem nach einem der vorhergehenden Ansprüche,
**dadurch gekennzeichnet,**
**dass** zumindest die p-Schicht als elektrisch leitende Kunststofffarbe ausgebildet ist, in der die Halbleiterelemente wie Silizium, oder Kupfer-Indium-Diselenid oder Galliumarsenid eingebracht sind.

**13.** Beschichtungssystem nach einem der vorhergehenden Ansprüche,
**dadurch gekennzeichnet,**
**dass** zwischen den beiden Halbleiterschichten (8, 9) die nichtleitende Grenzschicht (11) vorgesehen ist, die ebenfalls als streichbare Masse ausgebildet ist.

**14.** Beschichtungssystem nach einem der vorhergehenden Ansprüche,
**dadurch gekennzeichnet,**
**dass** auf der oberen n-dotierten Halbleiterschicht (8) aufgebrachte Leiterbahnen, Leitflächenteile oder ein Leitgitter (5) mit Hilfe eines Haftverbinders fixiert sind.

**15.** Beschichtungssystem nach einem der vorhergehenden Ansprüche,
**dadurch gekennzeichnet,**
**dass** die einzelnen Schichten (8, 9, 11, 14) aus einem fließ- oder schüttfähigen Material bestehen und nacheinander auf eine Oberfläche aufgetragen werden.
